(19) Europäisches Patentamt

European Patent Office

Office européen des brevets

(11) EP 1 463 125 A2

(12) EUROPEAN PATENT APPLICATION

(43) Date of publication:
29.09.2004 Bulletin 2004/40

(51) Int Cl.7: H01L 31/075, H01L 31/18, H01L 31/20

(21) Application number: 04007131.8

(22) Date of filing: 24.03.2004

(84) Designated Contracting States:
AT BE BG CH CY CZ DE DK EE ES FI FR GB GR HU IE IT LI LU MC NL PL PT RO SE SI SK TR
Designated Extension States:
AL LT LV MK

(30) Priority: 26.03.2003 JP 2003085879

(71) Applicant: CANON KABUSHIKI KAISHA
Ohta-ku, Tokyo (JP)

(72) Inventor: Kariya, Toshimitsu
Tokyo (JP)

(74) Representative:
Leson, Thomas Johannes Alois, Dipl.-Ing.
Patentanwälte
Tiedtke-Bühling-Kinne & Partner,
Bavariaring 4
80336 München (DE)

(54) **Stacked photovoltaic element and current balance adjustment method**

(57) A stacked photovoltaic element contains a structure formed by sequentially arranging a metal layer 103, a lower transparent conductive layer 104, a first n-layer 105 of non-single-crystal silicon, a first i-layer 106 of microcrystal silicon, a first player 108 of non-single-crystal silicon, a second n-layer 109 of non-single-crystal silicon, a second i-layer 110 of microcrystal silicon and a second player 112 of non-single-crystal silicon on a support body 102. The first i-layer 106 and the second i-layer 110 are made to contain phosphor and the content ratio R1 of phosphor to silicon of the first i-layer 106 and the content ratio R2 of phosphor to silicon of the second i-layer 110 are defined by the formula of R2 < R1. With this arrangement, photovoltaic elements showing a high conversion efficiency can be manufactured with a high yield factor.

FIG. 1

EP 1 463 125 A2

Printed by Jouve, 75001 PARIS (FR)

**Description**

BACKGROUND OF THE INVENTION

Field of the Invention

This invention relates to a photovoltaic element and, more particularly, it relates to a solar battery. More particularly, the present invention relates to an improvement to the conversion efficiency and the yield factor of stacked solar batteries having two or more than two pin junctions formed by using i-layers of microcrystal silicon ($\mu$c-Si:H) thin film. This invention also relates to a current balance adjustment method for each component cell of a stacked solar battery formed by using i-layers of microcrystal silicon thin film.

Related Background Art

In recent years, thin film solar batteries formed by using a silicon based non-single-crystal (and non-polycrystalline) semiconductor have been attracting attention from the viewpoint of encouraging the use of electric power generated by solar energy because such a solar battery can be formed on a relatively less expensive substrate such as a glass or metal sheet to make it show a large surface area and a small thickness if compared with a solar battery formed by using a single-crystal or polycrystalline semiconductor and hence large area solar batteries can be manufactured at low cost.

However, thin film solar batteries have not been used on a large scale because the conversion efficiency of thin film solar batteries is low and they are subject to photo-degradation when compared with crystalline silicon solar batteries. Therefore, efforts have been and are being paid to improve the performance of thin film solar batteries.

For example, researches for utilizing a material showing a large long-wavelength absorption coefficient relative to amorphous silicon for i-layers of solar batteries are intensively under way. Unlike amorphous thin film such as a-SiGe:H, for instance, $\mu$c-Si:H is practically free from photo-degradation and, additionally, does not require the use of expensive raw material gas such as germane gas ($GeH_4$). While $\mu$c-Si:H thin film does not have an absorption coefficient as high as a-SiGe:H thin film, it is possible for a $\mu$c-Si:H single cell to obtain a short circuit current (Jsc) that is stronger than that of an a-SiGe:H single cell when the film thickness of the i-layer is made greater than 2 $\mu$m.

For instance, MRS Symposium Proceeding, Vol. 420, Amorphous Silicon Technology 1996, pp. 3-13, "On the Way towards High Efficiency Thin-Film Silicon Solar Cells by the Micromorph Concept", by J. Meier et al. describes that the authors achieved a conversion efficiency of 7.7% in a single cell having a single pin junction, where the i-layer was made of $\mu$c-Si:H, that was prepared by means of VHF plasma CVD, using a frequency of 110 MHz. The single cell had a remarkable advantage that it was free from photo-degradation. The above document also describes that the authors also achieved a conversion efficiency of 13.1% in a stacked cell (double cell) prepared by additionally forming another pin junction, where the i-layer was made of amorphous silicon based thin film (a-Si:H).

Japan Journal of Applied Physics Vol. 36 (1997), pp. L569-L572, Part 2, No. 5A, "Optical Confinement Effect for below 5 $\mu$m Thick Film Poly-Si Solar Cell on Glass Substrate", by Kenji Yamamoto et al., Kaneka Corporation describes that the authors achieved a conversion efficiency of 9.8% in a single cell having a pin junction of poly-Si and $\mu$c-Si. The i-layer of the cell was 3.5 $\mu$m, which is thin for a poly-Si single cell, although the short circuit current (Jsc) was 26 mA/cm$^2$, which is relatively large. The above document also describes that the authors also achieved a conversion efficiency of 12.8% in a stacked cell (double cell) prepared by additionally forming another pin junction, where the i-layer was made of amorphous silicon based thin film (a-Si:H).

Furthermore, 26th Photovoltaic Specialists Conference 1997, "Thin Film Poly-Si Solar Cell with Star Structure on Glass Substrate Fabricated at Low Temperature", Kenji Yamamoto, Masashi Yoshimi et al. describes that the authors achieved a post-photo-degradation conversion efficiency of 11.5% in a stacked cell (triple cell) having three pin junctions, where the i-layers were made of a-Si:H thin film /$\mu$c-Si:H thin film / $\mu$c-Si:H thin film respectively.

Japanese Patent Application Laid-Open No. H11-251610 discloses a technique of turning an i-layer of $\mu$c-Si: H thin film into a weak n-type or p-type layer by adding a valence electron control agent to a slight extent.

Japanese Patent Application Laid-Open No. H11-310495 discloses a technique of adding phosphor to an i-layer of $\mu$c-Si:H thin film to a ratio of 1ppm .

Japanese Patent Application Laid-Open No. H11-317538 discloses a technique of adding phosphor-containing gas to the raw material gas to a ratio between about 10ppm and about 1,000ppm in order to form an n$^-$ layer in a photovoltaic element having a p$^+$n$^-$n$^+$ junction of $\mu$c-Si:H thin film.

Japanese Patent Application Laid-Open No. H11-243218 discloses a photovoltaic element comprising a bottom cell and a middle cell each formed by using an i-layer of $\mu$c-Si:H thin film and a top cell formed by using an i-layer of a-Si:H.

It is well known to form a rear surface reflection-layer in order to return sun light that was not absorbed by a thin film semiconductor layer back to the thin film semiconductor layer by controlling the surface profile of a substrate and raising its reflectance so as to effectively utilize incident light. For example, when causing sun light to strike the surface of a thin film semiconductor layer, a remarkable internal light confinement effect is realized to improve the short circuit current by forming a layer of a metal having a high reflectance such as silver (Ag) or aluminum (Al) on a substrate, forming a transparent electro-conductive layer made of ZnO or $SnO_2$ and having appropriate surface undulations thereon, and forming a photovoltaic layer further thereon. For instance, as disclosed in Japanese Patent Application Laid-Open No. 2000-22189, a transparent electro-conductive layer of ZnO can be formed by combining sputtering and electro-deposition.

## SUMMARY OF THE INVENTION

Photovoltaic elements (to be referred to simply as cells hereinafter) having an i-layer of $\mu$c-Si:H thin film that can produce a short circuit current of 30 mA/cm$^2$ or more are currently available. Such cells have properties that cannot be obtained by cells having an i-layer of a-SiGe:H thin film. Additionally, while cells having an i-layer of a-SiGe:H thin film are accompanied by a serious problem of photo-degradation, some cells having an i-layer of $\mu$c-Si:H thin film are free from the problem of photo-degradation. Furthermore, while cells having an i-layer of a-SiGe:H thin film need to be formed by using expensive gas such as $GeH_4$, cells having an i-layer of $\mu$c-Si:H thin film can be formed without using such expensive raw material gas. Thus, cells having an i-layer of $\mu$c-Si:H thin film provides a number of advantages.

On the other hand, however, photovoltaic elements having an i-layer of $\mu$c-Si:H thin film are accompanied by a problem that the conversion efficiency of a single cell that has a single pin junction is as low as about 10%. The inventor of the present invention prepared a stacked cell (double cell) comprising a light receiving top cell having an i-layer of a-Si:H thin film and a rear side bottom cell having an i-layer of $\mu$c-Si:H thin film and adjusted the current balance of each component cell. As a result, the initial conversion efficiency was as high as 12%.

However, double cells of the above-described type were accompanied by a serious problem of photo-degradation. As a result of research efforts, it was found that the photo-degradation was caused mainly because the film thickness of the i-layer of the top cell had been increased to 400 nm as a result of the current balance adjustment. Thus, the inventor of the present invention prepared a stacked cell (triple cell) comprising a top cell having an i-layer of a-Si:H thin film, a middle cell having an i-layer of $\mu$c-Si:H thin film arranged under the top cell and a bottom cell having an i-layer of $\mu$c-Si:H thin film arranged under the middle cell and conducted an experiment for suppressing photo-degradation by reducing the film thickness of the i-layer of a-Si:H thin film.

To adjust the current balance of a stacked cell, it is desirable to adjust the band gap of the i-layer of each component cell so as to minimize the overlap of the spectral sensitivity curves of the component cells. For this purpose, it is then desirable to lay i-layers having different band gaps one on the other in the descending order of band gaps. In other words, an i-layer having a large band gap needs to be arranged at the light receiving side, while an i-layer having a small band gap needs to be arranged at the rear side. Additionally, the current balances of the component cells need to be made uniform by adjusting the film thickness of the i-layer of each component cell. The uniform current value to be achieved is the value obtained by dividing the largest Jsc value that is obtained for a single cell by the number of cells in the stack (the number of pin junctions).

In the case of a double cell prepared in a manner as described above, where the cells are connected in series, sun light can be effectively converted into electricity because the open-circuit voltage of the top cell and that of the bottom cell show a large difference. Therefore, the current balances can be adjusted simply by adjusting the film thicknesses.

The inventor of the present invention conducted an experiment of changing the band gap of the component cells having an i-layer of a triple cell comprising two i-layers of $\mu$c-Si:H thin film when adjusting the current balance of each component cell. As a result, it was possible to change the open-circuit voltage of each i-layer of $\mu$c-Si:H thin film from 0.40 eV to 0.62 eV. However, a cell whose open-circuit voltage could be changed from 0.40 eV to 0.47 eV showed only a small short-circuit current in spite of the low open-circuit voltage. Such a cell cannot find practical applications. A cell whose open-circuit voltage could be changed from 0.55 eV to 0.62 eV, on the other hand, was subject to photo-degradation to a large extent. Such a cell cannot find practical applications either. In other words, the range of open-circuit voltage that can be used in the middle cell and the bottom cell of a triple cell of the above-described type is very narrow and limited to between 0.48 eV and 0.54 eV to provide limitations to band gap adjustment.

Additionally, adjustment of current balance needs to mainly rely on adjustment of film thickness. When adjustment of current balance is limited to adjustment of film thickness, it is not possible to achieve a large open-circuit voltage for a triple cell and the wavelength selectivity of the spectral sensitivity spectrum of each component cell is practically lost. Then, such a cell cannot provide effective photoelectric conversion. Additionally, it is difficult to control the film thickness of each component cell so that the generated electric current of the bottom cell fluctuates as the film thickness of the middle cell fluctuates and vice versa. Then, as a result, the current balance is lost to reduce the conversion efficiency.

A triple cell having i-layers of μc-Si:H thin film as described in Japanese Patent Application Laid-Open No. H11-243218 is accompanied by the same problems.

In view of the above identified problems, it is therefore an object of the present invention to dissolve the above problems by providing a new current balance adjustment method for adjusting the current balance of a stacked cell (triple cell in particular) having two or more than two i-layers of μc-Si:H thin film. It is another object of the present invention to provide a photovoltaic element whose current balance is adjusted by the adjustment method.

The inventor of the present invention found a phenomenon that the spectral sensitivity of a single cell having an i-layer of μc-Si:H thin film can be controlled for a specific wavelength by adjusting the phosphor (P) content ratio of the i-layer of the single cell and got to the present invention by applying the above phenomenon to current balance adjustment of a stacked cell (triple cell in particular) with intensive research efforts.

In an aspect of the present invention, there is provided a current balance adjustment method for a stacked photovoltaic element containing a structure formed by sequentially arranging a first n-layer of non-single-crystal silicon, a first i-layer microcrystal silicon, a first p-layer of non-single-crystal silicon, a second n-layer of non-single-crystal silicon, a second i-layer of microcrystal silicon and a second p-layer of non-single-crystal silicon, said method comprising causing said first i-layer and said second i-layer to contain spectral sensitivity adjusting atoms and adjusting the current balance by adjusting the concentration of spectral sensitivity adjusting atoms.

Preferably, said spectral sensitivity adjusting atoms are phosphor (P) atoms.

In another aspect of the invention, there is provided a photovoltaic element containing a structure formed by sequentially arranging a metal layer, a lower transparent conductive layer, a first n-layer of non-single-crystal silicon, a first i-layer of microcrystal silicon, a first p-layer of non-single-crystal silicon, a second n-layer of non-single-crystal silicon, a second i-layer of microcrystal silicon and a second p-layer of non-single-crystal silicon on a support body, said first i-layer and said second i-layer containing phosphor (P) and the content ratio R1 of phosphor to silicon of the first i-layer and the content ratio R2 of phosphor to silicon of the second i-layer is defined by the formula of

$$R2 < R1.$$

Preferably, said structure is formed by additionally and sequentially laying a third n-layer of non-single-crystal silicon, a third i-layer of amorphous silicon and third p-layer of non-single-crystal silicon and an upper transparent conductive layer of ITO on and in contact with said second p-layer.

Preferably, the relationship of said content ratios R1 and R2 is defined by the formula of

$$0.1ppm < R2 < R1 < 4ppm.$$

With the current balance adjustment method according to the invention, the spectral sensitivity of the stacked cell relative to a specific wavelength is adjusted by causing the i-layers of μc-Si:H thin film to contain spectral sensitivity adjusting atoms and adjusting the current balance of the stacked cell. The mechanism involved in the method will be described in greater detail hereinafter. With the current balance adjustment method according to the invention, it is possible to raise or lower the sensitivity of the stacked cell relative to light with a wavelength band between 550 nm and 800 nm without changing the band gap of the i-layers by adjusting the phosphor content ratio of the i-layers of μc-Si:H thin film. The adjustment range is modified by changing the phosphor content ratio between about 0.1ppm and about 4ppm so that there is no risk that the instability at the time of forming the layers entails reduction in the conversion efficiency and in the yield factor of stacked cells of the type under consideration.

BRIEF DESCRIPTION OF THE DRAWINGS

FIG. 1 is a schematic cross sectional view of an embodiment of stacked photovoltaic element according to the invention, showing its configuration;

FIG. 2 is a schematic cross sectional view of a photovoltaic element (single cell) having an i-layer of μc-Si:H thin film;

FIG. 3 is a graph illustrating the relationship between the phosphor concentration of the i-layer and the Voc characteristic of the photovoltaic element of FIG. 2;

FIG. 4 is a graph illustrating the relationship between the phosphor concentration of the i-layer and the FF characteristic of the photovoltaic element of FIG. 2;

FIG. 5 is a graph illustrating the relationship between the phosphor concentration of the i-layer and the Jsc characteristic of the photovoltaic element of FIG. 2;

FIG. 6 is a graph illustrating the relationship between the phosphor concentration of the i-layer and the conversion efficiency of the photovoltaic element of FIG. 2;

FIG. 7 is a graph illustrating the relationship between the phosphor concentration of the i-layer and the spectral sensitivity characteristic of the photovoltaic element of FIG. 2;

FIG. 8 is a graph illustrating the relationship between the phosphor concentration of the i-layer and the spectral sensitivity characteristic of the photovoltaic element of FIG. 2;

FIG. 9 is a schematic illustration of a roll-to-roll type sputtering system that can be used for manufacturing a substrate for a photovoltaic element according to the invention;

FIG. 10 is schematic illustration of a roll-to-roll type electro-deposition system that can be used for manufacturing a substrate for a photovoltaic element according to the invention;

FIG. 11 is a schematic illustration of a system that can be used for forming a bottom cell, a middle cell and a top cell on a substrate of photovoltaic element according to the invention by means of a roll-to-roll type CVD method; and

FIG. 12 is a schematic view of a photovoltaic element as viewed from the light receiving side thereof.

## DESCRIPTION OF THE PREFERRED EMBODIMENTS

Now, the present invention will be described in greater detail by referring to the accompanying drawings that illustrate preferred embodiments of the invention.

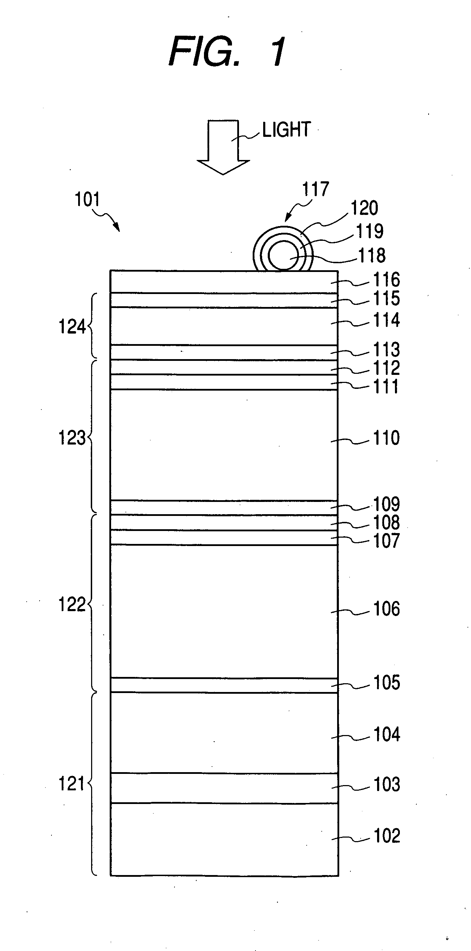

FIG. 1 is a schematic cross sectional view of an embodiment of stacked photovoltaic element according to the invention, showing its configuration. Referring to FIG. 1, the stacked photovoltaic element 101 contains a structure formed by sequentially arranging a metal layer 103, a lower transparent conductive layer 104, a first n-layer 105 of non-single-crystal silicon, a first i-layer 106 of microcrystal silicon, a first p-layer 108 of non-single-crystal silicon, a second n-layer 109 of non-single-crystal silicon, a second i-layer 110 of microcrystal silicon and a second p-layer 112 of non-single-crystal silicon on a support body 102. The structure additionally has a third n-layer 113 of non-single-crystal silicon, a third i-layer 114 of amorphous silicon and third p-layer 115 of non-single-crystal and an upper transparent conductive layer 116 on and in contact with the second p-layer 112.

A metal plate such as stainless steel plate or a glass plate is used for the support body 102. The metal layer 103 is laid on the support body 102 by evaporation, sputtering or electro-deposition. The metal layer 103 may have a multilayer structure of different metals. In any case, however, it is desirable that the metal layer 103 has a surface of Ag, Al, Cu or some other metal having a high reflectance at the side opposite to the support body 102. A lower transparent conductive layer 104 of ZnO, $SnO_2$ $In_2O_3$, ITO or the like is laid on the metal layer 103 typically by sputtering, CVD or electro-deposition. Preferably, the surface of the metal layer and that of the lower transparent conductive layer are made to show a texture-like appearance in order to achieve a light-confining effect and the angle of inclination in micro-regions of the order of sub-microns on the surfaces is not less than 20 degrees and not more than 40 degrees.

The work obtained by laying a metal layer 103 and a lower transparent conductive layer 104 on a support body 102 is referred to as substrate 121 herein. Then, a first n-layer 105 of a-Si:H:P thin film, a phosphor-containing first i-layer 106 of $\mu$c-Si:H thin film, a first pi-layer 107 of a-Si:H thin film, a first p-layer 108 of a-Si:H:B or $\mu$c-Si:H:B are sequentially formed on the substrate 121 by CVD. The multilayer structure including the above four layers is referred to as bottom cell 122.

Then, a second n-layer 109 of a-Si:H:P thin film, a phosphor -containing second i-layer 110 of $\mu$c-Si:H thin film, a second pi-layer 111 of a-Si:H thin film, a second p-layer 112 of a-Si:H:B or $\mu$c-Si:H:B are sequentially formed on the bottom cell 122 also by CVD. The multilayer structure including the above four layers is referred to as middle cell 123.

Subsequently, a third n-layer 113 of a-Si:H:P thin film, a third i-layer 114 of a-Si:H thin film and a third p-layer 115 of a-Si:H:B or $\mu$c-Si:H:B are sequentially formed on the middle cell 123 also by CVD. The multilayer structure including the above three layers is referred to as top cell 124.

While the first pi-layer 107 and the second pi-layer 111 are not indispensable for the purpose of the present invention, they are preferably provided because the pi interface characteristic and also Voc and FF are improved when they are arranged.

Each of the layers of the bottom cell 122, the middle cell 123 and the top cell 124 is made of high quality thin film that contains hydrogen and in which defective levels such as dangling bonds are almost completely compensated.

Subsequently, an upper transparent conductive layer 116 of ZnO, $SnO_2$ $In_2O_3$, ITO or the like is formed on the top cell 124 by sputtering or resistance heating. The use of ITO is particularly desirable as material of the upper transparent conductive layer. It is desirable to make the upper transparent conductive layer have a film thickness of about 70 nm and the reflectance of the layer become lowest at and near the wavelength of 520 nm.

Then, a comb-shaped current collecting electrode 117 is formed on the upper transparent conductive layer 116. It is desirable that the current collecting electrode 117 is prepared by forming an Ag clad layer 119 and a carbon clad layer 120 around a Cu wire 118 by application and fusion-bonding the prepared current collecting electrode 117 to the upper transparent conductive layer.

It is desirable that the above-described metal layer 103, the lower transparent conductive layer 104, the bottom cell 122, the middle cell 123, the top cell 124 and the upper transparent conductive layer 116 are formed by a roll-to-roll method for the purpose of improving the productivity. Note that the i-layers may not necessarily be of intrinsic conductive type. They may be of weak p-type or weak n-type conductive type.

The inventor of the present invention found a phenomenon that the spectral sensitivity of a single cell having an i-layer of μc-Si:H thin film can be controlled for a specific wavelength by adjusting the phosphor concentration of the i-layer of the single cell and applied this phenomenon to current balance adjustment of a triple cell. Therefore, firstly the phenomenon will be described below.

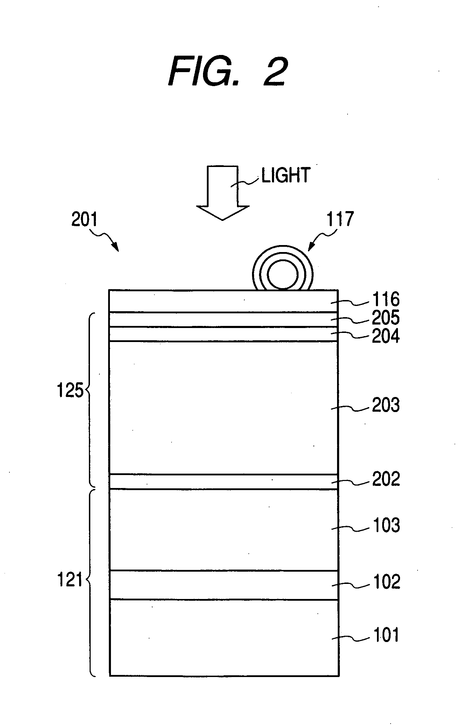

FIG. 2 is a schematic cross sectional view of a photovoltaic element 201 comprising a single cell 125 having an i-layer of μc-Si:H thin film. The single cell 125 has a single pin junction including an i-layer 203 of μc-Si:H thin film. The materials and the forming processes of the layers are same as those described above by referring to FIG. 1. An upper transparent conductive layer 116 is laid on the p-layer 205.

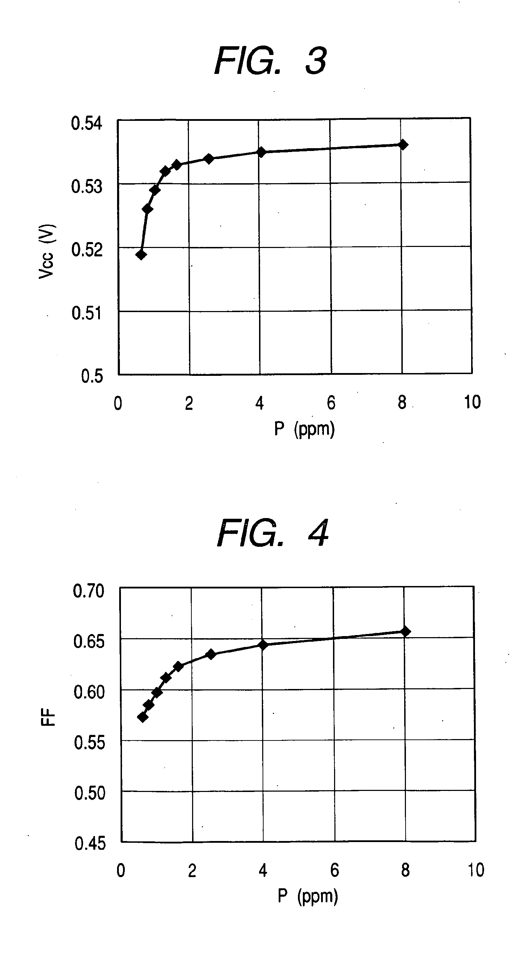

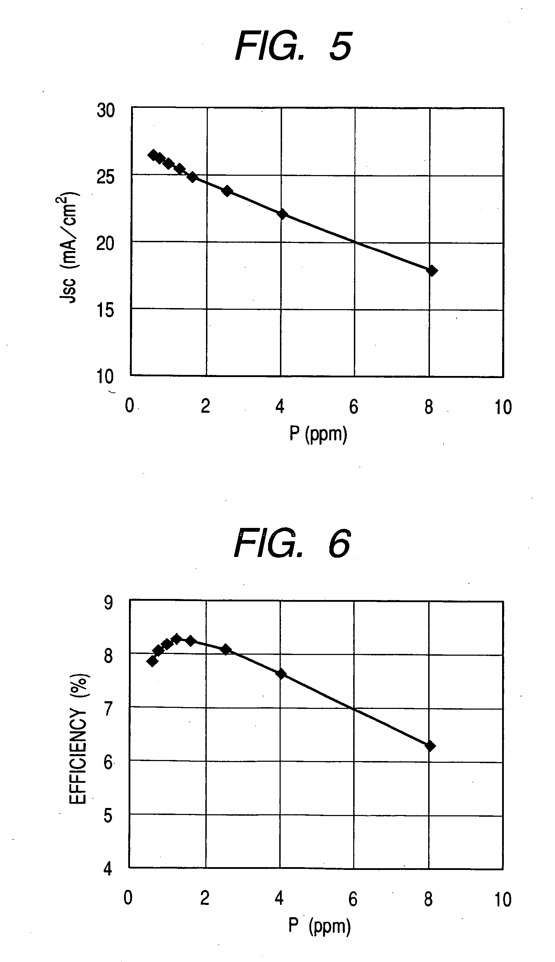

FIGS. 3 through 6 are graphs illustrating the relationships between the phosphor concentration of the i-layer and various characteristics of the single cell of FIG. 2 obtained by controlling the volume of $PH_3$ gas introduced simultaneously with $SiH_4$ gas, $SiF_4$ gas and $H_2$ gas into the vacuum chamber that was used for forming the i-layer 203 of the single cell by CVD. As seen from the graphs, the relationship between the P concentration in the i-layer and Voc (see FIG. 3) and the relationship between the P concentration in the i-layer and FF (see FIG. 4) show a substantially same tendency. More specifically, both Voc and FF increase monotonically until the P content ratio gets to 1ppm from the lower side and the rate of increase is reduced beyond 1ppm of the P content ratio until they become saturated. As for the relationship between the P concentration in the i-layer and Jsc, Jsc decreases monotonically as the P concentration in the i-layer increases (see FIG. 5). As for the relationship between the P concentration in the i-layer and the conversion efficiency, the conversion efficiency monotonically increases until the P concentration gets to 2ppm from the lower side and then slowly and monotonically decreases beyond 2ppm of the P concentration (see FIG. 6). It will be appreciated from the graphs that the highest conversion efficiency is realized when the P concentration in the i-layer of μc-Si:H thin film of a single cell is found at or near 2ppm.

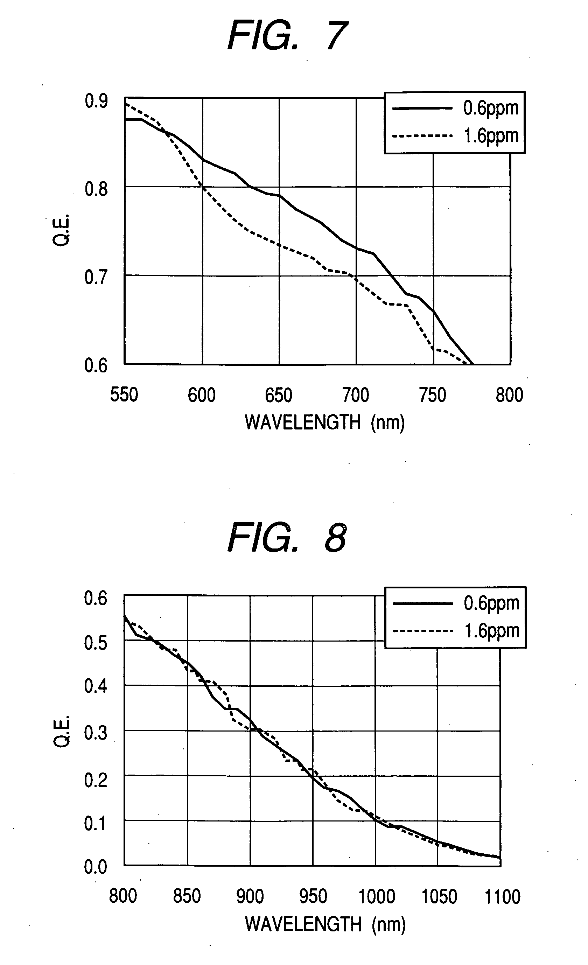

Since both the i-layer of μc-Si:H thin film of the bottom cell and that of the middle cell of a stacked photovoltaic element according to the invention contain phosphor, the two cells show a high FF value and therefore the triple cell including the two cells also shows a high FF value. Particularly, the bottom cell shows very high Voc and FF values due to the phosphor it contains. While the Jsc value decreases as the phosphor concentration rises as seen from FIG. 5, the spectral sensitivity relative to light with a wavelength range above 800 nm is sufficient for the bottom cell as seen from FIG. 8. Additionally, the spectral sensitivity of the middle cell is sufficient for a middle cell as seen from FIG. 7 because the phosphor concentration of the middle cell is low.

When a thin film that cannot change the band gap is used as i-layer, the method of adjusting the current balance of the bottom cell and that of the middle cell is normally employed under the conditions where the highest efficiency is obtained. However, according to the present invention, the level of spectral sensitivity that is required to the middle cell can be controlled by controlling the P concentration in the i-layer of μc-Si:H thin film.

It is believed that a large number of amorphous regions normally exist in high quality μc-Si:H thin film that is used for photovoltaic elements and phosphor is deposited exclusively in amorphous regions or on crystal grain boundaries. Many dangling bonds of silicon exist on crystal grain boundaries of μc-Si:H thin film in which amorphous regions are practically not found. However, dangling bonds are quite rare on crystal grain boundaries of μc-Si:H thin film in which many amorphous regions exist because gaps separating crystals are surrounded by amorphous regions. The i-layers of μc-Si:H thin film in a photovoltaic element according to the invention are basically in such a state. However, local levels attributable to dangling bonds and structural strains will not be completely removed in such a state. If phosphor is put into μc-Si:H thin film in such a state, phosphor in crystals seem to move to crystal boundaries and become bonded to hydrogen atoms in amorphous regions in the process of forming the photovoltaic element to consequently inactivate dangling bonds.

$$Si^* + P \rightarrow Si\text{-}P^*$$

$$Si\text{-}P^* + 2H^* \rightarrow Si\text{-}PH_2$$

While μc-Si:H thin film is formed by CVD (gas phase chemical reaction), the above reaction does not take place on the outermost surface of the film but it is a solid phase reaction that takes place in the thin film forming process.

However, since the small number of phosphor atoms that are added to amorphous regions do not move during the thin film forming process and hence amorphous regions turn to slightly n-type regions, it may be safe to assume that depletion is prevented from occurring. Therefore, probably absorption takes place only in absorbing regions of amorphous silicon and the sensitivity to light with a wavelength range between 550 nm and 800 nm is reduced to by turn reduce the short circuit current as the phosphor concentration increases. The fact that the dangling bond density of high quality $\mu$c-Si:H thin film is about $1 \times 10^{15}$ to $1 \times 10^{16}$ (1/cm$^3$) and the concentration of the added phosphor is of the order of $1 \times 10^{16}$ (1/cm$^3$) also suggests the above described mechanism.

If PH$_3$ gas is used as raw material gas when phosphor is introduced into $\mu$c-Si:H thin film, PH$_2$* is excited in plasma so that probably the following reactions take place on the outermost surface.

$$PH3 \rightarrow PH_2{}^* + H^*$$

$$Si^* + PH_2{}^* \rightarrow Si\text{-}PH_2$$

Meanwhile, when phosphor is added to a large extent , phosphor atoms that do not take part in compensation of dangling bonds on crystal grain boundaries come to overflow in crystals so that the crystals in the i-layer of $\mu$c-Si:H thin film seem to turn to n-type crystals to suppress depletion of the i-layer. Additionally, the large amount of phosphor encourages amorphous regions to turn to n-type regions and suppresses depletion similarly. Therefore, this may be the reason why Jsc decreases as the phosphor concentration increases.

If the phosphor content ratio of the i-layer of the bottom cell and that of the i-layer of the middle cell of a stacked photovoltaic element according to the invention are R1 and R2 respectively, preferably the relationship of R1 and R2 is defined by the formula of

$$0.1ppm < R2 < R1 < 4ppm.$$

More specifically, since the i-layer of the' middle cell contains phosphor only to a small extent, it is possible to improve the spectral sensitivity relative to the wavelength range between 550 nm and 800 nm when the i-layer has a small film thickness. Then, additionally, light can get to the bottom cell to a large extent because of the small film thickness of the i-layer of the middle cell, it is also possible to improve the spectral sensitivity of the bottom cell.

Furthermore, since the i-layer of the bottom cell contains phosphor to a relatively large extent, it is possible to achieve a high open-circuit voltage and a high FF value so that the spectral sensitivity to the wavelength range between 800 nm and 1100 nm of the bottom cell is sufficiently high.

Still additionally, since the i-layer of the middle cell does not contain amorphous regions to a large extent, it is free from photo-degradation. Furthermore, since the film thickness is not controlled to adjust the delicate current balance, the conversion efficiency does not fluctuate if the film thickness of the i-layer of the middle cell and that of the bottom cell unpredictably come to show fluctuations during the process of forming them.

Now, the present invention will be described further by way of examples.

(Example 1)

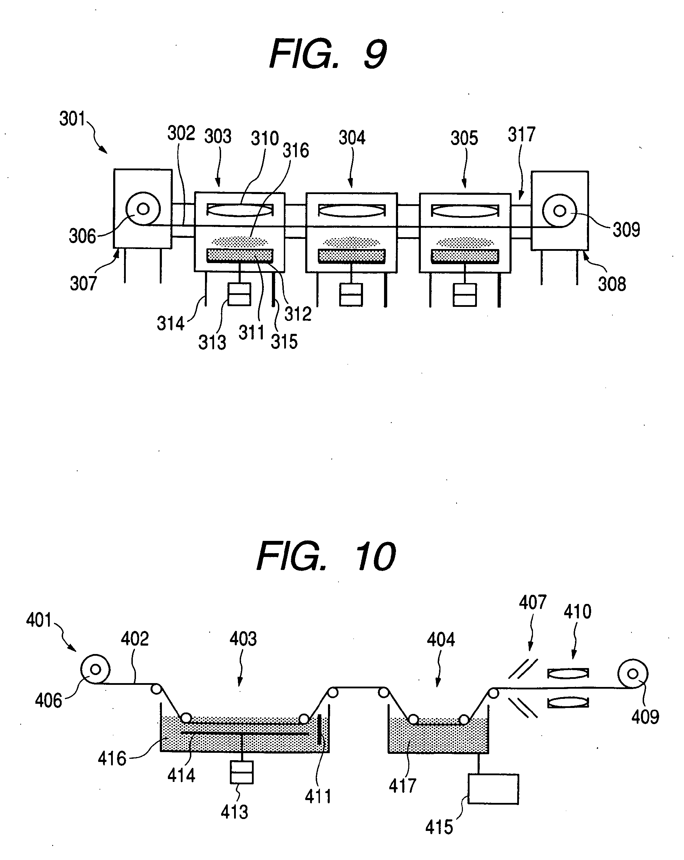

A photovoltaic element as shown in FIG. 1 was prepared in this example. Firstly, a substrate was prepared for a photovoltaic element according to the invention by using systems as shown in FIGS. 9 and 10.

FIG. 9 is a schematic illustration of a roll-to-roll type thin film forming system that is adapted to continuously form different thin films on a belt-shaped support body 302 respectively in different spaces. In FIG. 9, reference symbols 303, 304 and 305 denote vacuum chambers for forming thin film by DC sputtering. Different thin films can be formed by using different target materials. A Ti target, an Ag target and a ZnO target are used respectively in the vacuum chambers 303, 304 and 305 so that a Ti layer, an Ag layer and a ZnO layer can be formed sequentially on a support body.

In the inside of each of the vacuum chambers, a heater 310 is arranged to heat the belt-shaped support body 302 from the rear surface thereof whereas a target 311 and an electrode 312 that is connected to the target are arranged at the opposite side relative to the belt-shaped support body 302. A DC power source 313 is connected to each of the electrodes 312. Additionally, a gas supply pipe 314 is connected to each of the vacuum chamber so that raw material gas can be introduced into the vacuum chamber from a gas supply unit (not shown). Furthermore, an exhaust pipe 315 is connected to each of the vacuum chamber so that the inside of the vacuum chamber can be evacuated by means of a vacuum pump (not shown) to produce vacuum therein.

As drum 306 carrying the belt-shaped support body 302 wound around it and take-up drum 309 are driven to rotate, the belt-shaped support body 302 is moved from left to right in FIG. 9 so that thin films of different types can be formed simultaneously in respective different spaces.

Now, the operating procedures of the above system will be described below.

Firstly, a belt-shaped support body 302 is wound around the drum 306 to form a roll and set in position in the inside of vacuum chamber 307. The belt-shaped support body 302 is pulled out at the free end thereof and made to move through the vacuum chambers 303, 304, 305 and become wound around the drum 309 arranged in the inside of vacuum chamber 308. The vacuum chambers and the vacuum paths 317 connecting the vacuum chambers are evacuated by means of the vacuum pumps by way of the respective exhaust pipes connecting the vacuum chambers and the vacuum pumps respectively. Additionally, the belt-shaped support body 302 is heated to a predetermined temperature level by means of the heaters 310.

Then, Ar gas is introduced into the vacuum chambers from the respective gas supply pipes at a flow rate of 50 sccm and the internal pressure is held to 3 Pa. Then, a voltage is applied to the electrodes of the vacuum chambers to generate plasma 316 in the vacuum chambers. At this time, the DC power and the moving speed of the belt-shaped support body are adjusted to make the thicknesses of the Ti layer, the Ag layer and the ZnO layer respectively equal to 50 nm, 800 nm and 200 nm. A metal layer 103 is formed by the laminate of the Ti layer and the Ag layer. The thin film forming process using the system of FIG. 9 was terminated when a metal layer and a ZnO layer were formed to an effective length of 100m on the belt-shaped support body.

FIG. 10 is a schematic illustration of a system 401 adapted to form a ZnO layer on the ZnO layer formed by the sputtering system 301 of FIG. 9 by means of a roll-to-roll type electro-deposition method. The system 401 comprises an electro-deposition tank 403 for forming a ZnO layer by electro-deposition, a washing water tank 404, an air knife 407 and a heater 410. The electro-deposition tank 403 is filled with an electro-deposition producing solution 416 and a zinc electrode 414 is arranged vis-à-vis the support body 402, on which the ZnO layer is formed in the sputtering system of FIG. 9, and connected to a DC power source 413. The film thickness of the ZnO layer that is formed in the system 401 can be controlled by way of the moving speed of the support body 402 and the current density of the electric current flowing to the electrode 414. The washing water tank 404 is filled with pure water 417 and connected to a pure water supply unit 415.

Now, the procedures for forming a ZnO film by means of the electro-deposition system 401 of FIG. 10 will be described below.

Firstly, a support body 402 on which a ZnO layer is formed by the sputtering system of FIG. 9 is wound around the drum 406 to form a roll. Then, it is pulled out at the free end thereof and made to move through the electro-deposition producing solution 416, the pure water 417, the air knife 407 and the heater 410 and become wound around drum 409. As the drums 406 and 409 are driven to rotate, the support body 402 is moved from left to right so that different treatments can be conducted simultaneously in respective different spaces. As the electro-deposition producing solution 416, an aqueous solution of 0.2 mol/L of zinc nitrate and 0.1 g/L of dextrin is heated to 80°C by solution heater 411 in a controlled manner. The power source 413 is controlled so as to produce an electric current of 8.0 mA/cm$^2$ that flows to the electrode 414. The electro-deposition producing solution adhering to the surface of the ZnO film and the rear film of the support body is washed off in the pure water tank 404. Additionally, pure water drops are evaporated by means of the air knife 407 and the heater 410. The support body 402 is heated by the heater 410 to about 120°C. A ZnO layer was formed continuously while taking up the support member 402 by the drum 409. The ZnO layer forming process using the electro-deposition system of FIG. 10 was terminated when a substrate was formed to an effective length of 100m.

A ZnO layer was formed by means of the above described process to a film thickness of 2.6 µm. Since a ZnO layer had been formed on the substrate to a film thickness of 0.4 µm in advance by means of the sputtering system of FIG. 9, the film thickness of the lower transparent conductive layer 104 of ZnO layer is 3.0 µm.

The procedure for forming the substrate 121 is described above. The light reflection characteristics of the prepared substrate 121 were examined to find that the regular reflection was 90% and the diffused reflection was 80%, while the hazing ratio was 89% and hence that the substrate 121 was a high quality texture substrate.

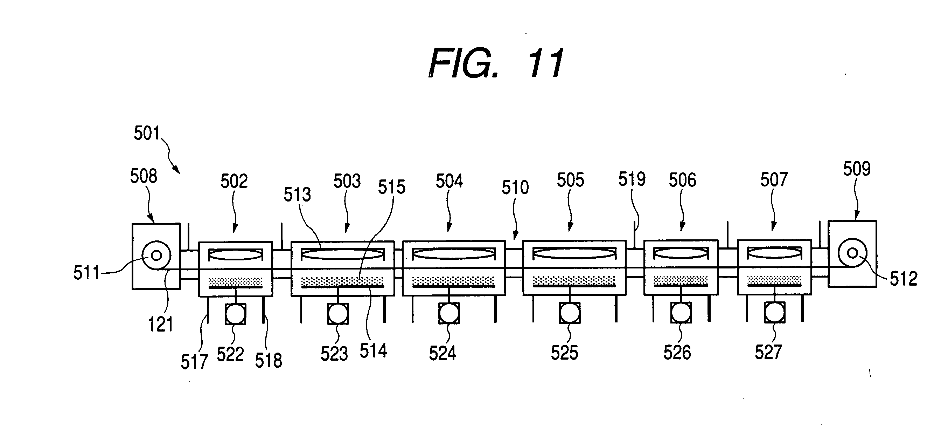

FIG. 11 is a schematic illustration of a system to be used for forming a bottom cell 122, a middle cell 123 and a top cell 124 by means of a roll-to-roll type CVD method on the substrate 121 that is formed by using the system of FIGS. 9 and 10. The system 501 comprises vacuum chambers 502, 503, 504, 505, 506, 507, 508, 509 and vacuum paths 510 linking the vacuum chambers.

The vacuum chamber 508 is used to feed out the substrate, which is wound around a drum 511 to form a roll, to the downstream vacuum chambers and the vacuum chamber 509 is used to take up the substrate, which carries a bottom cell and a middle cell, around a drum 512.

The vacuum chamber 502 is a chamber for forming the first and second n-layers and the vacuum chambers 503, 504, 505 are chambers for forming the first and second i-layers, while the vacuum chamber 506 is a chamber for forming the first and second pi-layers and the vacuum chamber 507 is a chamber for forming the first and second p-layers. A raw material gas supply pipe 517 and an exhaust pipe 518 are connected to each of the vacuum chambers and a path gas supply pipe 519 is connected to each of the vacuum paths. As path gas is supplied to the path gas supply pipes 519 at a predetermined rate, mutual diffusion of raw material gas can be suppressed to take place among the vacuum chambers. A raw material gas supply unit (not shown) is connected to each of the raw material gas supply pipes 517, while each of the vacuum chambers 502, 503, 504, 505, 506, 507 is provided in the inside thereof with a heater 513 for heating the substrate from the rear surface thereof and an electrode 514 for generating high frequency plasma 515. The electrodes 514 are connected to respective high frequency power sources 522, 523, 524, 525, 526, 527. With this system 501 again, thin films of different types can be formed simultaneously in respective different spaces while the substrate is moved.

Now, the procedures for forming a bottom cell 122 by means of the system 501 of FIG. 11 will be described below.

Firstly, a substrate 121, which is wound around a drum 511 to form a roll, is pulled out at the free end thereof and made to pass through the vacuum paths and the vacuum chambers sequentially so that it is taken up by and wound around drum 512. Then, the vacuum chambers and the vacuum paths are evacuated to produce vacuum therein to a predetermined pressure level by means of the vacuum pumps connected to the respective vacuum chambers. Additionally, the substrate 121 is heated to a predetermined temperature level by means of the heaters 513 and the drums 511, 512 are driven to rotate in order to start conveying the substrate 121. $H_2$ gas is made to flow at a rate of about 2slm to each of the path gas supply pipes and predetermined raw material gas is introduced into each of the vacuum chambers from the raw material gas supply pipe connected to the vacuum chamber. Then, the conductance valves (not shown) of the vacuum chambers are operated for adjustment for the purpose of holding the internal pressure of each of the vacuum chambers to a predetermined pressure level. Additionally, high frequency power is supplied to the electrode 514 arranged in the inside of each of the vacuum chambers at a predetermined rate to generate high frequency plasma. The thin film forming process using the system of FIG. 11 is terminated when a bottom cell 122 is formed to an effective length of 100m on the substrate 121. Table 1 below shows the conditions for forming the layers of the bottom cell 122 of a photovoltaic element according to the invention.

Then, a middle cell 123 was prepared by using a system as shown in FIG. 11 and following similar procedures. Table 1 below also shows the conditions for forming the layers of the middle cell 123 of a photovoltaic element according to the invention.

Thereafter, a top cell 124 was prepared by using a system as shown in FIG. 11 and following similar procedures. Table 1 below also shows the conditions for forming the layers of the top cell 124 of a photovoltaic element according to the invention.

Then, the Ti target was replaced by an ITO target with 3 wt% of $SnO_2$ and an upper transparent electro-conductive layer 116 of ITO was formed to a film thickness of 70 nm by following similar procedures.

Then, the 100m long photovoltaic element formed on the belt-shaped support body was cut to 25 cm long pieces to produce 400 photovoltaic elements.

Table 1

| layer | Material | film thickness (nm) | gas flow rate (sccm) | | | | | Pressure (Pa) | frequency (MHz) | power (W) | Temperature (°C) |
|---|---|---|---|---|---|---|---|---|---|---|---|
| | | | $SiH_4$ | $H_2$ | $PH_3$ | $BF_3$ | $SiF_4$ | | | | |
| 1st n-layer | A | 100 | 10 | 1000 | 0.4 | | | 600 | 13.56 | 200 | 250 |
| 1st i-layer | M | 3400 | 150 | 3500 | 0.00024 | | 500 | 600 | 60 | 2000 | 150 |
| 1st pi-layer | A | 100 | 25 | 2500 | | | | 600 | 13.56 | 200 | 150 |
| 1st p-layer | M | 50 | 15 | 15000 | | 4.5 | | 600 | 13.56 | 1600 | 150 |
| 2nd n-layer | A | 100 | 7.5 | 500 | 0.9 | | | 600 | 13.56 | 200 | 200 |
| 2nd i-layer | M | 1900 | 150 | 3300 | 0.00009 | | 500 | 600 | 60 | 2000 | 150 |
| 2nd pi-layer | A | 100 | 50 | 3000 | | | | 600 | 13.56 | 200 | 150 |
| 2nd p-layer | M | 50 | 25 | 15000 | | 7.8 | | 600 | 13.56 | 2000 | 150 |
| 3rd n-layer | A | 50 | 20 | 1000 | 0.08 | | | 266 | 13.56 | 100 | 200 |
| 3rd i-layer | A | 200 | 500 | 6000 | | | | 266 | 60 | 400 | 240 |
| 3rd p-layer | M | 50 | 20 | 5000 | | 0.1 | | 266 | 13.56 | 3000 | 150 |

EP 1 463 125 A2

In table 1, material A is amorphous silicon and material M is microcrystal silicon.

Then, the photovoltaic elements were subjected to a shunt passivation process. More specifically, potassium hydroxide was dissolved to a small extent as pH regulator in 1% aqueous solution of sulfuric acid to make the aqueous solution show a pH value of 1.7. Then, each of the photovoltaic elements having a length of 25 cm were immersed in the aqueous solution. A positive electrode was arranged vis-à-vis the upper transparent conductive layer 116 and a sinusoidal wave voltage having the highest voltage of 3V, the lowest voltage of 0V and a cycle period of 1 second was applied to the electrode to remove the upper transparent conductive layer at and near the short-circuit section. The low illuminance Voc at 200 lux of each and every photovoltaic element subjected to this process was above 1.0(V) and no short-circuited photovoltaic element was found.

Thereafter, wire grids formed by applying an Ag clad layer and a carbon clad layer to Cu wires were arranged at regular intervals of 5 mm and fusion-bonded to the upper transparent conductive layer 116. Then, the ends of the wire grids were connected to Cu tabs that were coated with Ag to produce a current collecting electrode 117.

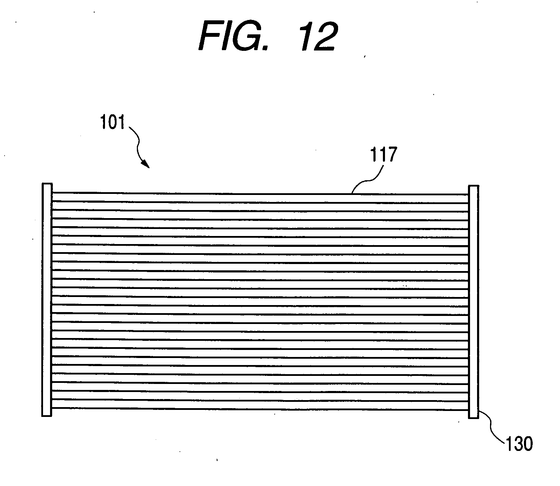

Photovoltaic elements (triple cells) 101 having the configuration illustrated in FIG. 1 were prepared by way of the above-described steps. FIG. 12 is a schematic view of one of the photovoltaic elements as viewed from the light receiving side thereof.

The characteristics of the photovoltaic elements were observed by means of a solar simulator adjusted to AM1.5 and 100 mW/cm$^2$. Table 2 shows the average values obtained by observing the characteristics of the 400 photovoltaic elements. The phosphor content ratios of the first i-layer and the second i-layer were observed by means of SIMS to find that they were respectively 1.6ppm and 0.6ppm relative to silicon.

(Example for Comparison 1)

A total of 400 triple cells were prepared as in Example 1 except that the phosphor concentration in the i-layer of the middle cell was made equal to its counterpart of the i-layer of the bottom cell and the current balance was adjusted by raising the film thickness of the i-layer of the middle cell. The characteristics of the photovoltaic elements were observed by means of a solar simulator. Table 2 also shows the average values obtained by observing the characteristics of the 400 photovoltaic elements of this example for comparison.

Table 2

|  | conversion efficiency (%) | Voc (V) | Jsc (mA/cm$^2$ ) | FF |
|---|---|---|---|---|
| Example 1 | 13.4 | 1.90 | 10.1 | 0.696 |
| example for comparison 1 | 12.6 | 1.91 | 9.51 | 0.694 |

As seen from Table 2, it was found that a photovoltaic element (Example 1) according to the invention shows a conversion efficiency higher than a known photovoltaic element (Example for Comparison 1).

The Jsc dispersion of the 400 specimens of Example for Comparison 1 was more remarkable than the Jsc dispersion of the 400 specimens of Example 1. While the yield factor of Example 1 was 97%, that of Example for Comparison 1 was as low as 90%. It was found that the Jsc dispersion of Example for Comparison 1 was attributable to instability of electric discharges. As a result, it was also found that photovoltaic elements according to the invention practically do not show any dispersion of conversion efficiency and can be manufactured with a high yield factor so that a current balance adjustment method according to the invention is advantageous relative to comparable known methods.

(Example 2)

Photovoltaic elements were prepared as in Example 1 except that a substrate having a 2.8 μm thick ZnO layer formed by sputtering was used as lower transparent conductive layer 104 and hence no ZnO layer was formed by electro-deposition. As a result, characteristics and a yield factor as excellent as those of Example 1 were observed.

(Example 3)

Photovoltaic elements were prepared as in Example 1 except that PH$_3$ gas was caused to flow into the vacuum chambers at a rate of 0.01 sccm during the step of forming the i-layer of the bottom cell. As a result, characteristics and a yield factor as excellent as those of Example 1 were observed.

As described above in detail, it is possible to manufacture photovoltaic elements showing a high conversion efficiency with a high yield factor according to the invention by using a current balance adjustment method according to the invention.

A stacked photovoltaic element contains a structure formed by sequentially arranging a metal layer 103, a lower transparent conductive layer 104, a first n-layer 105 of non-single-crystal silicon, a first i-layer 106 of microcrystal silicon, a first p-layer 108 of non-single-crystal silicon, a second n-layer 109 of non-single-crystal silicon, a second i-layer 110 of microcrystal silicon and a second p-layer 112 of non-single-crystal silicon on a support body 102. The first i-layer 106 and the second i-layer 110 are made to contain phosphor and the content ratio R1 of phosphor to silicon of the first i-layer 106 and the content ratio R2 of phosphor to silicon of the second i-layer 110 are defined by the formula of $R2 < R1$. With this arrangement, photovoltaic elements showing a high conversion efficiency can be manufactured with a high yield factor.

## Claims

1.  A stacked photovoltaic element comprising a structure formed by sequentially arranging a metal layer, a lower transparent conductive layer, a first n-layer of non-single-crystal silicon, a first i-layer of microcrystal silicon, a first p-layer of non-single-crystal silicon, a second n-layer of non-single-crystal silicon, a second i-layer of microcrystal silicon and a second p-layer of non-single-crystal silicon on a support body, said first i-layer and said second i-layer containing phosphor and the content ratio R1 of phosphor to silicon of the first i-layer and the content ratio R2 of phosphor to silicon of the second i-layer are defined by the formula of

$$R2 < R1.$$

2.  An element according to claim 1, wherein
    said structure is formed by additionally and sequentially laying a third n-layer of non-single-crystal silicon, a third i-layer of amorphous silicon and third p-layer of non-single-crystal silicon and an upper transparent conductive layer of ITO on and in contact with said second p-layer.

3.  An element according to claim 1, wherein
    the relationship of said content ratios R1 and R2 is defined by the formula of

$$0.1ppm < R2 < R1 < 4ppm.$$

4.  A current balance adjustment method for a stacked photovoltaic element containing a structure formed by sequentially arranging a first n-layer of non-single-crystal silicon, a first i-layer of microcrystal silicon, a first p-layer of non-single-crystal silicon, a second n-layer of non-single-crystal silicon, a second i-layer of microcrystal silicon and a second p-layer of non-single-crystal silicon, said method comprising causing said first i-layer and said second i-layer to contain spectral sensitivity adjusting atoms and adjusting the current balance by adjusting the concentration of the spectral sensitivity adjusting atoms.

5.  A method according to claim 4, wherein
    said spectral sensitivity adjusting atoms are phosphor atoms.

# FIG. 1

# FIG. 2

## FIG. 3

## FIG. 4

# FIG. 5

# FIG. 6

# FIG. 7

# FIG. 8

## FIG. 9

## FIG. 10

EP 1 463 125 A2

## FIG. 11

# FIG. 12